(19) Europäisches Patentamt
European Patent Office
Office européen des brevets

(11) Numéro de publication: **0 053 082 B1**

# (12) FASCICULE DE BREVET EUROPEEN

(45) Date de publication du fascicule du brevet: **31.10.84**

(51) Int. Cl.³: **H 03 K 19/003**

(21) Numéro de dépôt: **81401865.1**

(22) Date de dépôt: **24.11.81**

(54) **Système logique de sécurité pour déclencher l'action de protection d'un actionneur de sûreté.**

(30) Priorité: **26.11.80 FR 8025068**

(43) Date de publication de la demande: **02.06.82 Bulletin 82/22**

(45) Mention de la délivrance du brevet: **31.10.84 Bulletin 84/44**

(84) Etats contractants désignés: **BE DE GB IT**

(56) Documents cités:
**US - A - 3 424 652**
**US - A - 3 681 578**
**US - A - 3 735 356**

**IEEE TRANSACTIONS ON COMPUTERS, vol. C-29, no. 3, mars 1980, IEEE New York, US S.Y.H. SU et al.: "A Hardware Redundancy Reconfiguration Scheme for Tolerating Multiple Module Failures", pages 254-258**

(73) Titulaire: **COMMISSARIAT A L'ENERGIE ATOMIQUE Etablissement de Caractère Scientifique Technique et Industriel, 31/33, rue de la Fédération, F-75015 Paris (FR)**
Titulaire: **Framatome, Tour Fiat 1 place de la Coupole, F-92400 Courbevoie (FR)**
Titulaire: **MERLIN GERIN, Rue Henri Tarze, F-38050 Grenoble Cedex (FR)**

(72) Inventeur: **Plaige, Yves, COMM A L'ENERGIE ATOMIQUE 15, Avenue des Tilleuls, F-91440 Bures Sur Yvette (FR)**

(74) Mandataire: **Mongrédien, André et al, c/o BREVATOME 25, rue de Ponthieu, F-75008 Paris (FR)**

EP 0 053 082 B1

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention concerne un système logique de sécurité pour déclencher l'action de protection d'un actionneur de sûreté. Elle s'applique notamment aux déclenchements urgents d'actionneurs de sûreté commandant l'arrêt d'un réacteur nucléaire.

On sait qu'un réacteur nucléaire, par exemple, comprend un grand nombre de dispositifs qui permettent de contrôler son fonctionnement. Ces dispositifs sont qualifiés d'actionneurs de sûreté. En cas d'incident, ces actionneurs doivent pouvoir être déclenchés de façon urgente, de manière que leur action de protection puisse arrêter cet incident. Dans les réacteurs, on mesure les valeurs d'un certain nombre de grandeurs physiques, telles que la pression, la température, le flux neutronique, etc..., en un certain nombre de points. On compare ensuite dans différents appareils les valeurs de ces grandeurs avec des valeurs de référence. Ces appareils délivrent normalement un signal logique de comparaison qui est, par exemple, de valeur non nulle lorsque les valeurs des grandeurs physiques sont situées dans une fourchette de valeurs définies à l'avance, correspondant au fonctionnement normal du réacteur. Lorsque les grandeurs physiques sortent de cette fourchette de sécurité, les appareils du système délivrent un signal logique de sortie de valeur nulle par exemple. Ce sont les sorties de ces appareils qui sont reliées à chacune des quatre voies du système logique de sécurité, conforme à l'invention, qui sera décrit plus loin en détail.

On sait que les systèmes logiques de sécurité qui permettent de déclencher l'action de protection d'un actionneur de sûreté comprennent généralement plusieurs voies redondantes qui sont reliées par leurs sorties à des entrées d'un circuit logique de commande de déclenchement d'action de protection; ce circuit logique de commande est conçu de manière qu'une action de protection soit déclenchée, à chaque fois que plus d'une voie fournit un signal de commande de déclenchement d'action de protection, en réponse à un signal d'actionnement reçu par les différentes voies. On peut, par exemple déclencher l'action de protection, si p voies parmi un nombre m de ces voies, émettent un signal de déclenchement. En général, p est égal à 2 et m est égal à 4 si l'on veut pouvoir inhiber pour essai une voie du système. Dans la description de l'invention, on considérera par exemple que le système présente quatre voies redondantes et que l'action de protection est déclenchée à partir des signaux d'au moins deux voies. Les circuits à sécurité positive sont également bien connus des spécialistes de problèmes de sécurité. La sécurité dite positive d'un circuit est son aptitude à évoluer dans le sens de l'initiation de l'action pour laquelle il a été conçu, en cas de pannes dites »pannes sûres«, l'affectant, le taux des pannes non sûres étant réduit à une valeur très voisine de zéro. Il est bien évident que de tels circuits peuvent être utilisés, non seulement dans le domaine nucléaire, mais aussi dans tout autre domaine nécessitant des déclenchements d'action de protection.

On sait aussi que certains systèmes logiques de sécurité comprennent pour chacune des voies de commande un circuit logique d'alarme qui permet d'actionner cette voie de commande lorsqu'il reçoit un signal d'alarme sur une entrée, et un circuit logique d'inhibition de ce circuit logique d'alarme qui permet, lorsqu'il reçoit un signal de commande d'inhibition, d'isoler la voie de commande par rapport au circuit logique de commande de déclenchement d'action de protection; cette inhibition de la voie de commande est rendue nécessaire dans les systèmes logiques de sécurité, pour des tests par exemple, des circuits situés en amont du circuit logique d'actionnement; ces circuits situés en amont peuvent être, par exemple, des chaînes d'amplification et de traitement de signaux, reliées à des capteurs; ces capteurs permettent notamment de déterminer des paramètres physiques caractéristiques du fonctionnement d'une installation qui comporte des actionneurs dont l'action de protection doit être déclenchée en cas d'incident. Cette inhibition possible des voies de commande, dans un système logique de sécurité, bien que nécessaire pour des fonctions de tests, ne doit pas être effectuée sans précautions. Dans un circuit de sécurité de type, dit »2/4«, on peut envisager l'inhibition de l'une des voies pour vérification ou maintenance. Il est cependant interdit d'envisager l'inhibition simultanée de deux voies parmi quatre. En effet, tout système logique de sécurité doit respecter le critère de défaillance unique, qui impose que l'action de protection soit déclenchée en cas d'incident. L'inhibition d'une seule voie dans un circuit de sécurité »2/4« permet de respecter ce critère, mais l'inhibition de deux voies, ou a fortiori, de trois voies doit être interdite; en effet, si deux voies étaient inhibées et que survienne une défaillance (panne non sûre) dans l'une des deux voies restantes, le système de sécurité ne déclencherait pas l'action de protection, en cas de nécessité. Si l'on sait faire fonctionner des circuits logiques de sécurité, de type deux sur quatre, présentant quatre voies redondantes qui comprennent des circuits logiques d'alarme et d'inhibition, on ne sait pas, par contre, dans ces circuits »2/4« interdire de manière simple et sûre, l'inhibition de plusieurs voies.

L'invention a pour but de remédier à cet inconvénient et notamment de réaliser un système logique de sécurité pour déclencher l'action de protection d'un actionneur, ce système logique de sécurité comprenant quatre voies redondantes constituées chacune notamment par un circuit logique de commande de déclenchement d'action de protection, un circuit logique d'alarme relié au circuit de commande, et par un circuit logique d'inhibition grâce auquel il est impossible d'inhiber simultanément plusieurs circuits d'alarme. Comme on le verra plus loin en détail, toute tentative d'inhibition du circuit d'alarme d'une deuxième voie alors que le circuit d'alarme d'une première voie est déjà inhibé, provoque automatiquement, à la sortie de cette deuxième voie, l'apparition d'un signal de commande d'action de protection quel que soit le signal reçu à l'entrée du circuit d'alarme de cette deuxième voie.

L'invention a pour objet un système logique de sécurité pour déclencher l'action de protection d'un actionneur de sûreté, comprenant un nombre entier m de voies redondantes de commande de déclenchement d'action de protection, ces voies étant reliées par des sorties à des entrées d'un circuit logique de commande de déclenchement d'action de protection apte à déclencher cette action à chaque fois qu'au moins deux voies parmi les m voies ont fourni un signal de commande de déclenchement d'action de protection, en réponse à un signal d'alarme reçu par ces deux voies au moins, caractérisé en ce que chacune des voies comprend un circuit logique d'alarme apte à recevoir le signal d'alarme sur une entrée, un circuit logique d'inhibition du circuit logique d'alarme, apte à recevoir sur une entrée de commande, un signal de commande d'inhibition du circuit logique d'alarme, ce circuit d'inhibition étant relié à une entrée d'inhibition du circuit d'alarme apte à recevoir un signal d'inhibition de la voie correspondante, les circuits logiques d'alarme et d'inhibition de chaque voie étant constitués et reliés de manière que, lorsque le circuit logique d'inhibition d'une première voie parmi toutes les voies reçoit sur l'entrée de commande d'inhibition un signal de commande d'inhibition, alors que ce signal est déjà reçu par une entrée de commande d'inhibition d'un circuit logique d'inhibition d'une deuxième voie parmi toutes les voies, le circuit logique d'inhibition de cette première voie applique, par une sortie de sécurité sur une entrée de sécurité du circuit d'alarme correspondant, un signal de sécurité qui provique l'apparition sur une sortie du circuit d'alarme qui correspond à la sortie de cette première voie d'un signal de commande de déclenchement d'action de protection, quels que soient les signaux reçus sur les entrées d'alarme des circuits d'alarme des autres voies.

D'autres caractéristiques et avantages de l'invention ressortiront mieux de la description qui va suivre donnée en référence aux dessins annexés dans lesquels:

- la figure 1 représente schématiquement un premier mode de réalisation d'un système logique de sécurité conforme à l'invention,
- la figure 2 représente schématiquement un second mode de réalisation d'un système logique de sécurité conforme à l'invention,
- la figure 3 est un tableau qui donne les valeurs des signaux logiques apparaissant en des points caractéristiques du système de la figure 1,
- la figure 4 est un tableau qui donne les valeurs logiques des signaux apparaissant en des points caractéristiques du système de la figure 2.

La figure 1 représente schématiquement un premier mode de réalisation d'un système logique de sécurité, conforme à l'invention. Ce système logique permet de déclencher l'action de protection d'un actionneur de sûreté 1 qui agit, par exemple, sur le fonctionnement d'une installation en cas de défaillance de celle-ci. Cette défaillance peut être repérée, comme on l'a mentionné plus haut, par des signaux résultant de la comparaison de paramètres physiques qui sont fournis par des capteurs (non représentés) et qui sont comparés à des paramètres de référence; ces signaux de comparaison parviennent aux entrées d'alarme $D_1$, $D_2$, $D_3$, $D_4$ de différentes voies redondantes $V_1$, $V_2$, $V_3$, $V_4$ du système logique de sécurité conforme à l'invention. Ces voies sont reliées, par des sorties $A_1$, $A_2$, $A_3$, $A_4$, à des entrées d'un circuit logique de commande de déclenchement d'action de protection 2. Ce circuit logique peut être un circuit à sécurité positive, apte à déclencher l'actionneur 1 lorsqu'au moins deux des voies parmi les quatre voies ont fourni au circuit de commande de déclenchement 2, un signal de commande de déclenchement d'action de protection, en réponse à un signal d'actionnement reçu sur les entrées d'alarme $D_1$, $D_2$, $D_3$, $D_4$ de ces voies.

Dans les systèmes de sécurité, il est convenu que les signaux qui parviennent aux entrées d'alarme $D_1$, ..., $D_4$ des différentes voies sont normalement à l'état logique 1, en l'absence de défaillances signalées par les capteurs. Un ou plusieurs de ces signaux logiques provenant des capteurs situés en amont seront à l'état logique 0, en présence d'une ou plusieurs défaillances signalées.

La description qui suit correspond au choix de cette convention concernant les états logiques 0 et 1. Si la convention contraire était adoptée pour l'ensemble de l'installation de protection, la structure générale du système resterait identique, la modification ne portant que sur les éléments logiques internes en appliquant les règles bien connues de l'homme de l'art pour passer de la logique précédemment définie (normal état 1, déclenchement état 0) à la logique complémentaire.

Sur la figure, $I_1$, $I_2$, $I_3$, $I_4$ désignent des entrées de commande qui permettent de faire parvenir à chacune des voies, un signal de commande d'inhibition. Chacune des voies comprend un circuit logique d'alarme 3, et un circuit logique d'inhibition 4; ce circuit d'inhibition 4 agit sur le circuit logique d'alarme 3 comme on le verra plus loin en détail. En l'absence d'inhibition de chacune des voies, les entrées $I_1$, ..., $I_4$ de commande d'inhibition des voies sont normalement à l'état logique 0. Lorsque l'une des voies doit être inhibée afin de tester, par exemple, la chaîne d'amplification et de traitement ainsi que le capteur situés en amont, un signal de commande d'inhibition du circuit logique d'alarme, de niveau logique 1, est appliqué sur l'entrée de commande d'inhibition de la voie correspondante. Dans chacune des voies, une sortie $S_{12}$ du circuit d'inhibition 4 est reliée à une entrée d'inhibition 6 du circuit d'alarme 3. Cette entrée d'inhibition reçoit un signal d'inhibition, si sur l'entrée de commande d'inhibition $I_1$ par exemple, est appliqué un signal de commande d'inhibition de niveau logique 1.

Il est bien évident que les différentes voies sont identiques et que l'on expliquera seulement en détail la structure et le fonctionnement de la voie $V_1$. Le circuit logique d'alarme 3 et le circuit logique d'inhibition 4, sont constitués et reliés de manière que lorsque le circuit logique d'inhibition d'une première voie telle que la voie $V_1$ par exemple reçoit sur son entrée de commande d'inhibition $I_1$, un signal d'inhibition de niveau logique 1, alors qu'un signal de commande d'inhibition était déjà reçu par une entrée de commande d'inhibition $I_2$ d'une deuxième voie $V_2$ par exemple, le circuit logique d'inhibition 4 de la première voie $V_1$ agit sur le circuit logique d'alarme 3, de manière que sur la sortie $A_1$ de ce circuit apparaisse un signal de déclenchement d'action de protection. Ce signal de déclenchement de l'action de protection dans les systèmes de sécurité présente généralement le niveau logique 0. Dans ce cas et comme on le verra plus loin en détail, le circuit logique d'inhibition 4 de la voie $V_1$ applique par une sortie de sécurité $S_{11}$ sur une entrée de sécurité 5 du circuit d'alarme 3 un signal de sécurité qui provoque l'apparition sur la sortie $A_1$ du circuit d'alarme, d'un signal de commande de déclenchement d'action de protection. Le circuit d'inhibition 4 de chaque voie comprend trois autres entrées de sécurité $E_{11}$, $E_{12}$, $E_{13}$.

Sur la figure 1, les trois entrées de sécurité $E_{11}$, $E_{12}$, $E_{13}$, sont reliées respectivement aux sorties $S_{42}$, $S_{32}$, $S_{22}$ des circuits d'inhibition (non représentés) des trois autres voies. De cette façon, le circuit d'inhibition 4 de la première voie $V_1$ applique par sa sortie $S_{12}$ connectée à l'entrée $E_{21}$ parmi les trois entrées de sécurité ($E_{21}$, $E_{22}$, $E_{23}$) du circuit d'inhibition (non représenté) d'une autre voie telle que $V_2$, un autre signal de sécurité; ce signal, comme on le verra par la suite, provoquera l'apparition d'un signal de déclenchement de protection sur la sortie $A_2$ de cette voie, si le circuit d'alarme 3 de la première voie était déjà inhibé. Ce signal de déclenchement sur la sortie $A_2$ est un signal de niveau logique 0, selon les conventions données précédemment.

Dans ce premier mode de réalisation du système conforme à l'invention, chaque circuit logique d'alarme 3 comprend une porte $ET_1$ d'alarme à deux entrées (6, $D_1$); l'entrée $D_1$ est apte à recevoir, comme indiqué plus haut, un signal d'alarme de niveau logique 0, tandis qu'une autre entrée 6 constitue l'entrée d'inhibition du circuit d'alarme 3. Le circuit d'alarme comprend également une porte $OU_1$ d'alarme à deux entrées 5, 7; l'entrée 7 est reliée à la sortie de la porte $ET_1$, tandis que l'entrée 5 qui constitue l'entrée de sécurité du circuit d'alarme est reliée à la sortie de sécurité $S_{11}$ du circuit d'inhibition. La sortie de cette porte $OU_1$ constitue la sortie $A_1$ du circuit d'alarme 3.

Le circuit logique d'inhibition 4 de chaque voie comprend un inverseur INV, dont l'entrée $I_1$ est apte à recevoir le signal de commande d'inhibition de niveau logique 1. La sortie $S_{12}$ de cet inverseur est reliée, comme on l'a vu plus haut, à l'entrée d'inhibition 6 du circuit d'alarme et aux entrées $E_{ij}$ de sécurité des autres voies, telles que les entrées $E_{23}$, $E_{33}$, $E_{43}$ des voies $V_2$, $V_3$, $V_4$. Le circuit logique d'inhibition 4 comprend également une porte $ET_2$ d'inhibition à deux entrées 8, 9; la première entrée 8 est reliée à l'entrée $I_1$ de l'inverseur INV; une porte $OU_2$ d'inhibition à deux entrées 10, 11 est reliée d'une part à la sortie de la porte $ET_2$ et d'autre part, à la sortie d'une autre porte $ET_3$ à quatre entrées $E_{11}$, $E_{12}$, $E_{13}$, $E_{14}$, l'entrée $E_{14}$ étant reliée à l'entrée $I_1$ de commande d'inhibition; la sortie $S_{11}$ de la porte $OU_2$ est reliée d'une part à l'autre entrée 9 de la porte $ET_2$ et d'autre part, à l'entrée de sécurité 5 de la porte $OU_1$ du circuit d'alarme 3. La porte $ET_3$ comporte quatre entrées; trois de ces entrées ($E_{11}$, $E_{12}$, $E_{13}$) constituent les entrées de sécurité du circuit d'inhibition. Comme on l'a vu plus haut, l'entrée $E_{14}$ de cette porte est reliée à l'entrée $I_1$ de l'inverseur INV, tandis que les trois autres entrées $E_{12}$, $E_{13}$, $E_{14}$ sont reliées respectivement aux sorties $S_{22}$, $S_{32}$, $S_{42}$ des inverseurs des circuits d'inhibition des autres voies. Le circuit bouclé réalisé entre la sortie $S_{11}$ de la porte $OU_2$ et l'entrée 9 de la porte $ET_2$ permet de rendre le circuit d'inhibition 4 indépendant de l'état des entrées $E_{11}$, $E_{12}$, $E_{13}$ dèsque l'inhibition de la voie devient effective.

Le fonctionnement du système qui vient d'être décrit sera expliqué plus loin en détail.

La figure 2 représente schématiquement un autre mode de réalisation d'un système logique de sécurité conforme à l'invention. Sur cette figure, on n'a représenté que deux des voies redondantes $V_1$, $V_2$ parmi les quatre voies du système logique. La voie $V_1$ est représentée de manière plus détaillée sur la figure. Chacune des voies, identique à la voie $V_1$, comprend une entrée $D_1$ apte à recevoir un signal d'alarme permettant le déclenchement de l'action de protection d'un actionneur 1 qui intervient rapidement dans le fonctionnement d'une installation non représentée sur la figure.

Comme dans le mode de réalisation précédent, ce déclenchement est réalisé par l'intermédiaire du circuit 2 de commande de déclenchement.

Comme dans le premier mode de réalisation, le système comprend aussi une entrée de commande d'inhibition $I_1$ qui permet d'isoler la voie correspondante du dispositif 1 afin de tester par exemple la chaîne d'amplification et de traitement ainsi que le capteur situés en amont de cette voie. Chacune des voies comporte un circuit logique d'alarme 3 et un circuit d'inhibition 4; dans ce mode de réalisation du système conforme à l'invention, le circuit logique d'alarme 3 est apte à recevoir un signal d'alarme sur son entrée $D_1$ de niveau logique 0, tandis que le circuit logique d'inhibition est apte à recevoir sur son entrée $I_1$ un signal de commande d'inhibition de niveau logique 1. Une connexion $S_{13}$ relie l'entrée $I_1$ du circuit d'inhibition à une entrée d'inhibition 6 du circuit d'alarme 3. Cette entrée d'inhibition reçoit un signal d'inhibition. Les circuits logiques 3, 4 d'alarme et d'inhibition sont constitués et reliés de manière que lorsque le circuit logique 4 d'inhibition de la voie $V_1$ par exemple reçoit sur son entrée $I_1$, un signal de commande d'inhibition alors que ce signal a été aussi reçu par une entrée $I_2$ du circuit logique d'inhibition d'une autre voie (telle que la voie $V_2$ par exemple), le circuit logique 4 d'inhibition de la voie $V_1$ commande le circuit logique d'alarme 3 de cette voie, de manière qu'apparaisse sur la sortie $A_1$ un signal de déclenchement d'action de protection.

A cet effet, le circuit logique d'inhibition 4 applique par une sortie de sécurité $S_{11}$ sur une entrée de sécurité 5 du circuit d'alarme 3, un signal de sécurité qui provoque l'apparition sur la sortie $A_1$ de ce circuit du signal de commande de déclenchement d'action de protection; ce signal de commande est appliqué au circuit logique de commande 2.

Dans ce second mode de réalisation du système conforme à l'invention, le circuit d'inhibition de chaque voie comprend trois entrées de sécurité $E_{11}$, $E_{12}$, $E_{13}$; une sortie $S_{12}$ du circuit d'inhibition est reliée respectivement à l'une des trois entrées de sécurité ($E_{23}$, $E_{33}$, $E_{43}$) des circuits d'inhibition des trois autres voies. Le circuit d'inhibition 4 de la première voie applique ainsi par sa sortie connectée à l'une des trois entrées de sécurité des circuits d'inhibition des autres voies, un autre signal de sécurité qui provoque le déclenchement de la protection sur toute autre voie que l'on tenterait d'inhiber, quel que soit le signal présent à l'entrée d'alarme de cette voie.

Dans ce mode de réalisation du système conforme à l'invention, le circuit logique d'alarme 3 comprend une porte $OU_1$ à deux entrées 6, $D_1$; l'une de ces entrées est celle qui reçoit éventuellement un signal d'alarme tandis que l'autre entrée 6 constitue l'entrée de commande d'inhibition du circuit d'alarme 3. Ce circuit comprend également une porte $ET_1$ à deux entrées 5, 14; l'entrée 14 est reliée à la sortie de la porte $OU_1$, tandis que l'entrée 5 constitue l'entrée de sécurité du circuit d'alarme 3. Cette entrée de sécurité est reliée à la sortie de sécurité $S_{11}$ du circuit d'inhibition 4. La sortie $A_1$ de la porte $ET_1$ constitue la sortie du circuit d'alarme 3 de la voie $V_1$ considérée.

Le circuit logique 4 d'inhibition comprend pour chaque voie un inverseur INV dont une entrée $I_1$ est apte à recevoir le signal de commande d'inhibition; cette entrée est reliée à l'entrée de commande d'inhibition 6 de la porte $OU_1$ du circuit d'alarme 3. La sortie $S_{12}$ de cet inverseur constitue comme on l'a mentionné plus haut une sortie de sécurité du circuit d'inhibition. Cette sortie est reliée à chacune des trois entrées de sécurité des circuits d'inhibition des autres voies.

Le circuit d'inhibition comprend aussi une porte $ET_2$ à deux entrées 15, 15; une entrée 15 de cette porte est reliée à l'entrée $I_1$ de l'inverseur INV. Une première porte $OU_2$ à deux entrées 17, 18 est reliée par l'entrée 18, à la sortie de la porte $ET_2$; la sortie 19 de la porte $OU_2$ est reliée d'une part à l'entrée 16 de la porte $ET_2$ et d'autre part, à l'entrée 20 d'une deuxième porte $OU_3$ à deux entrées 20, 21. L'entrée 21 de la porte $OU_3$ est reliée à la sortie $S_{12}$ de l'inverseur INV. La sortie $S_{11}$, de cette deuxième porte $OU_3$ est reliée à l'entrée 13 de la porte $ET_1$ du circuit d'alarme 3.

Enfin, ce circuit d'inhibition comprend une porte $ET_3$ à trois entrées $E_{11}$, $E_{12}$, $E_{13}$; ces trois entrées constituent les entrées de sécurité du circuit d'inhibition, tandis que la sortie de cette porte $ET_3$ est reliée à l'entrée 17 de la première porte $OU_2$ du circuit d'inhibition. La sortie $S_{12}$ de l'inverseur INV est reliée comme on l'a vu plus haut, à chacune des entrées de sécurité des circuits d'inhibition des autres voies. De la même manière, les autres sorties de sécurité des trois autres voies sont reliées respectivement aux trois entrées de sécurité $E_{11}$, $E_{12}$, $E_{13}$ du circuit d'inhibition de la première voie.

La figure 3 est un tableau des valeurs logiques qui apparaissent en des points caractéristiques du système de sécurité conforme au premier mode de réalisation de l'invention représenté sur la figure 1.

Dans ce tableau, les valeurs 0 ou 1 désignent l'état logique des signaux présents à l'entrée $I_1$ du circuit d'inhibition 4, à l'entrée $D_1$ du circuit d'alarme 3, sur la sortie $S_{12}$ du circuit d'inhibition, sur les entrées de sécurité $E_{11}$, $E_{12}$, $E_{13}$, de ce circuit, à la sortie de chacune des portes $ET_1$, $ET_3$, $ET_2$, à la sortie $S_{11}$ qui commande l'entrée de sécurité du circuit d'alarme 5, et enfin sur la sortie $A_1$ de la voie $V_1$. $C_1$, $C_2$, $C_3$, $C_4$, $C_5$, $C_6$ désignent différents cas de fonctionnement du système de sécurité décrit précédemment.

Le cas $C_1$ correspond à un fonctionnement normal de l'installation sous surveillance, reliée en sortie de l'actionneur 1. On suppose dans ce cas, qu'aucun signal d'alarme n'est reçu à l'entrée $D_1$ de la voie $V_1$ et qu'aucun signal de commande d'inhibition n'est reçu à l'entrée $I_1$ du circuit d'inhibition de cette voie ainsi que sur les entrées d'inhibition des autres voies. Dans ce cas, l'entrée $I_1$ est à un niveau logique 0, tandis que l'entrée $D_1$ est à un niveau logique 1. Le fonctionnement des différentes portes ET et OU ainsi que le fonctionnement de l'inverseur INV étant bien connus dans l'état de la technique, on en déduit facilement l'état logique des signaux qui apparaissent aux points caractéristiques définis plus haut. Toutes les entrées de sécurité $E_{11}$, $E_{12}$, $E_{13}$, du circuit d'inhibition reçoivent des signaux logiques de niveau 1, en provenance des circuits d'inhibition des autres voies puisqu'aucune de ces voies ne reçoit un signal de commande d'inhibition. La sortie $A_1$ de la voie $V_1$ est alors au niveau logique 1; ce niveau correspond à l'absence de signal de déclenchement d'action de protection sur l'entrée correspondante du circuit logique de commande 2.

Le cas $C_2$ correspond à l'envoi d'un signal d'alarme sur l'entrée $D_1$ de la voie $V_1$; ce signal correspond à un niveau logique 0 sur l'entrée $D_1$ tandis que l'on suppose qu'aucun signal d'inhibition n'est reçu par cette voie puisque son entrée $I_1$ est au niveau 0. On suppose également qu'aucune des autres voies ne reçoit de signal de commande d'inhibition puisque les entrées de sécurité $E_{11}$, $E_{12}$, $E_{13}$ sont au niveau logique 1. Dans ce cas, la voie $V_1$ remplit sa fonction et sa sortie $A_1$ est au niveau 0, ce qui correspond à l'application d'un signal de déclenchement d'action de protection sur l'entrée correspondante du circuit logique de commande 2.

Le cas $C_3$ correspond à l'absence, puis à l'application d'un ordre d'alarme à l'entrée $D_1$ de la voie $V_1$ (signal logique de niveau 1 à l'entrée $D_1$ de cette voie, puis signal logique de niveau 0). On suppose d'autre part qu'un signal logique de commande d'inhibition est appliqué sur l'entrée $I_1$ (niveau 1), tandis qu'aucun signal de commande d'inhibition n'est reçu des autres voies, ce qui correspond à des signaux logiques de niveau 1 sur les entrées de sécurité $E_{11}$, $E_{12}$, $E_{13}$ de la voie $V_1$. On voit dans ce cas, que même si un ordre d'alarme est appliqué sur l'entrée $D_1$, le signal à la sortie $A_1$ de la voie $V_1$ reste au niveau 1, ce qui correspond à l'absence d'ordre de déclenchement d'action de protection à l'entrée correspondante du circuit logique de commande 2. On peut dire, pour résumer ce cas, que l'application d'un ordre de commande d'inhibition sur l'une des voies, alors que toutes les autres voies ne sont pas inhibées, maintient la sortie de la voie inhibée à un niveau logique 1 (absence de déclenchement d'action de protection), quel que soit le signal appliqué sur l'entrée de commande d'alarme de cette voie.

Le cas $C_4$ correspond à l'absence puis à l'application d'un ordre d'alarme (niveau 1, puis niveau 0) à l'entrée $D_1$ de la voie $V_1$, cette voie n'étant pas inhibée (niveau 0 sur l'entrée $I_1$ de commande d'inhibition). On suppose que l'une des autres voies, telle que $V_2$ a reçu un signal de commande d'inhibition, ce qui se traduit par un signal logique de niveau 0 sur l'entrée de sécurité $E_{13}$ de la voie $V_1$. Les voies $V_3$ et $V_4$ sont supposées non inhibées (niveau 1 sur les entrées de sécurité $E_{11}$, $E_{12}$). Dans ce cas, l'application d'un ordre d'alarme (passage du niveau 1 au niveau 0) sur l'entrée $D_1$ de la voie $V_1$, provoque l'apparition d'un signal de déclenchement de protection (passage du niveau 1 au niveau 0) sur la sortie $A_1$ de la voie $V_1$.

Le cas $C_5$ correspond à l'inhibition de la voie $V_2$ par exemple, qui se traduit par un signal de niveau 0 sur l'entrée de sécurité $E_{13}$, puis à la tentative d'inhibition de la voie $V_1$ (passage de $I_1$, du niveau 0 au niveau 1). Dans ce cas, la sortie $A_1$ de la voie $V_1$ passe du niveau 1 au niveau 0 (déclenchement d'action de protection). On peut dire, pour résumer ce cas, que l'application d'un ordre d'inhibition sur l'une des voies alors qu'une autre voie est déjà inhibée, provoque l'apparition d'un signal de déclenchement d'action de protection sur la sortie de la voie que l'on tente d'inhiber.

Le cas $C_6$ correspond à l'inhibition de la voie $V_1$ ($I_1$ au niveau logique 1), puis à l'inhibition de la voie $V_2$ (entrée de sécurité $E_{13}$ passant du niveau 1 au niveau 0). On a vu précédemment, que dans un tel cas, la voie $V_1$ étant la première inhibée, la sortie de la voie $V_2$ va appliquer au circuit logique 2 un signal de déclenchement de protection. La sortie $S_{22}$ de la voie $V_2$ passe du niveau 1 au niveau 0 informant les autres voies de la tentative d'inhibition de la voie $V_2$ qui a produit le signal de déclenchement. Dans le tableau, ce changement de niveau est visible dans la colonne correspondant à l'entrée de sécurité $E_{13}$ de la voie $V_1$. La sortie $A_1$ de la voie $V_1$ reste au niveau logique 1 (absence de déclenchement d'action de protection sur cette voie), même si l'entrée $D_1$ de cette voie reçoit un ordre d'alarme (signal appliqué à $D_1$ passant du niveau 1 au niveau 0). On peut dire, pour résumer ce cas, que lorsqu'une première voie est inhibée, la tentative d'inhibition d'une autre voie provoque le déclenchement de l'action de protection à la sortie de cette autre voie, tandis que la sortie de la première voie inhibée ne déclenche aucune action de protection (niveau logique 1 sur cette sortie), même si un ordre d'alarme est appliqué à son entrée.

Le tableau de la figure 4 représente pour les mêmes cas de fonctionnement $C_1, \ldots, C_6$ mentionnés plus haut, les niveaux logiques des signaux apparaissant en différents points caractéristiques du système conforme à l'invention et qui est représenté sur la figure 2. Ce tableau ne sera pas commenté en détail. $OU_1$, $ET_3$, $OU_2$, $OU_3$ désignent les niveaux logiques des signaux de sortie des portes correspondantes.

Dans le système logique de sécurité qui vient d'être décrit, chaque circuit logique de commande d'inhibition connaît en permanence l'état des inhibitions sur les autres voies redondantes du système. On a intêret, pour des raisons de sécurité, à choisir par convention des signaux actifs pour la transmission entre les différentes voies des informations d'inhibition, de sorte que toute coupure sur une liaison entre les circuits logiques d'inhibition des différentes voies peut être assimilée à une inhibition. Il en résulte qu'une telle coupure ne met pas en défaut la sûreté du système de sécurité. L'utilisation de circuits logiques dynamiques à sécurité positive dans la constitution du circuit 2 de commande d'action urgente permet d'obtenir un ensemble à très grande sûreté de fonctionnement.

**Revendications**

1. Système logique de sécurité pour déclencher l'action de protection d'un actionneur de sûreté (1), comprenant un nombre entier m de voies redondantes de commande de déclenchement d'action de protection ($V_1$, $V_2$, $V_3$, $V_4$), ces voies étant reliées par des sorties ($A_1$, $A_2$, $A_3$, $A_4$) à des entrées d'un circuit logique (2) de commande de déclenchement d'action de protection apte à déclencher cette action à chaque fois qu'au moins deux voies parmi les m voies ont fourni un signal de commande de déclenchement d'action de protection en réponse à un signal d'alarme reçu par ces deux voies au moins, caractérisé en ce que chacune des voies comprend un circuit logique d'alarme (3) apte à recevoir le signal d'alarme sur une entrée ($D_1$), un circuit logique d'inhibition (4) du circuit logique d'alarme (3) apte à recevoir sur une entrée de commande ($I_1$), un signal de commande d'inhibition du circuit logique d'alarme (3), ce circuit d'inhibition étant relié à une entrée d'inhibition (6) du circuit d'alarme apte à recevoir un signal d'inhibition de la voie correspondante, les circuits logiques d'alarme (3) et d'inhibition (4) de chaque voie étant constitués et reliés de manière que, lorsque le circuit logique d'inhibition (4) d'une première voie parmi toutes les voies reçoit sur l'entrée de commande d'inhibition ($I_1$) un signal de commande d'inhibition, alors que ce signal est déjà reçu par une entrée ($I_2$) de commande d'inhibition d'un circuit logique d'inhibition d'une deuxième voie parmi toutes les voies, le circuit logique d'inhibition (4) de cette première voie applique, par une sortie de sécurité ($S_{11}$) sur une entrée de sécurité (5) du circuit d'alarme correspondant, un signal de sécurité qui provoque l'apparition sur une sortie ($A_1$) du circuit d'alarme qui correspond à la sortie de cette première voie d'un signal de commande de déclenchement d'action de protection.

2. Système logique selon la revendication 1, caractérisé en ce que le circuit d'inhibition (4) de chaque voie comprend en outre m – 1 entrées ($E_{11}$, $E_{12}$, $E_{13}$) de sécurité reliées respectivement à des sorties de sécurité ($S_{22}$, $S_{32}$, $S_{42}$) des circuits d'inhibition des m – 1 autres voies, le circuit d'inhibition (4) de chaque voie appliquant ainsi par une sortie de sécurité ($S_{12}$) connectée respectivement à l'une des m – 1 entrées de sécurité de chaque circuit d'inhibition des autres voies, un autre signal de sécurité indiquant l'état inhibé ou non inhibé du circuit d'alarme de chaque voie.

3. Système selon la revendication 2, caractérisé en ce que chaque circuit logique d'alarme (3) comprend une porte ($ET_1$) d'alarme à deux entrées (6, $D_1$), l'une de ces entrées ($D_1$) étant apte à recevoir le signal d'alarme, tandis que l'autre entrée (6) constitue l'entrée d'inhibition de ce circuit, et une porte ($OU_1$) d'alerte à deux entrées (5, 7), l'une ce ces entrées (7) étant reliée à une sortie de la porte ($ET_1$), tandis qu'une autre entrée (5) de la porte ($OU_1$) constitue l'entrée de sécurité du circuit d'alarme reliée à la sortie de sécurité ($S_{11}$) du circuit d'inhibition (4), la sortie de cette porte ($OU_1$) constituant la sortie ($A_1$) du circuit d'alarme (3), reliée au circuit logique de commande (2).

4. Système selon la revendication 3, caractérisé en ce que chaque circuit logique d'inhibition (4) comprend un inverseur (INV) dont une entrée ($I_1$) est apte à recevoir le signal de commande d'inhibition, une sortie ($S_{12}$) de cet inverseur étant reliée à une entrée (6) de la porte ($ET_1$) d'alarme qui constitue l'entrée d'inhibition du circuit d'alarme (3), une première porte ($ET_2$) d'inhibition à deux entrées (8, 9) dont une première entrée (8) est reliée à l'entrée ($I_1$) de l'inverseur (INV), une deuxième porte ($OU_2$) d'inhibition à deux entrées (10, 11) dont une entrée (10) est reliée à la sortie de la première porte ($ET_2$) d'inhibition à deux entrées, la sortie ($S_{11}$) de la deuxième porte ($OU_2$) étant reliée, d'une part, à l'autre entrée (9) de la première porte ($ET_2$) d'inhibition à deux entrées et, d'autre part, à l'entrée de sécurité (5) de la porte ($OU_1$) d'alerte et une porte ($ET_3$) à m entrées ($E_{11}$, $E_{12}$, $E_{13}$, $Fe_{14}$), m – 1 de ces entrées constituant les m – 1 entrées de sécurité du circuit d'inhibition (4), la sortie (11) de cette porte ($ET_3$) à m entrées étant reliée à l'autre entrée (11) de la deuxième porte ($OU_2$) d'inhibition, la $m^{ième}$ entrée ($E_{14}$) de la porte ($ET_3$) à quatre entrées étant reliée à la sortie ($S_{12}$) de l'inverseur (INV), tandis que les m – 1 autres entrées ($E_{11}$, $E_{12}$, $E_{13}$) de cette porte sont reliées respectivement aux sorties ($S_{22}$, $S_{32}$, $S_{42}$) des inverseurs des circuits d'inhibition des trois autres voies.

5. Système selon la revendication 1, caractérisé en ce que le circuit d'inhibition (4) de chaque voie comprend m – 1 entrées de sécurité ($E_{11}$, $E_{12}$, $E_{13}$), une sortie ($S_{12}$) du circuit d'inhibition de chaque voie étant reliée respectivement à l'une des m – 1 entrées de sécurité des circuits d'inhibition des autres voies, le circuit d'inhibition de l'une des voies appliquant ainsi, par sa sortie ($S_{12}$) connectée à l'une des m – 1 entrées de sécurité des circuits d'inhibition des autres voies, un autre signal de sécurité indiquant l'état inhibé ou non inhibé du circuit d'alarme de chaque voie.

6. Système selon la revendication 5, caractérisé en ce que chaque circuit logique d'alarme (3) comprend une première porte ($OU_1$) d'alarme à deux entrées (6, $D_1$), l'une de ces entrées ($D_1$) étant apte à recevoir le signal d'alarme, tandis que l'autre entrée (6) constitue l'entrée d'inhibition de ce circuit, et une deuxième porte ($ET_1$) d'alarme à deux entrées (5, 14), l'une de ces entrées (14) étant reliée à une sortie de la première porte ($OU_1$) tandis qu'une autre entrée (5) de la deuxième porte ($ET_1$) constitue l'entrée de sécurité du circuit d'alarme reliée à la sortie de sécurité ($S_{11}$) du circuit d'inhibition (4), la sortie ($A_1$) de cette porte ($ET_1$) constituant la sortie du circuit d'alarme reliée au circuit logique de commande (2).

7. Système selon la revendication 6, caractérisé en ce que chaque circuit logique d'inhibition (4) comporte un inverseur (INV) dont une entrée ($I_1$) est apte à recevoir le signal de commande d'inhibition, cette entrée ($I_1$) étant en outre reliée à l'entrée (6) d'inhibition de la première porte ($OU_1$) d'alarme, une première porte ($ET_2$) d'inhibition à deux entrées (15, 16) dont une entrée (15) est reliée à l'entrée ($I_1$) de l'inverseur (INV), une deuxième porte ($OU_2$) d'inhibition à deux entrées (17, 18) dont une entrée (18) est reliée à la sortie de la première porte ($ET_2$) d'inhibition à deux entrées et dont la sortie (19) est reliée à l'autre entrée (16) de la première porte ($ET_2$) d'inhibition à deux entrées, une troisième porte ($OU_3$) d'inhibition à deux entrées (20, 21) dont une entrée (20) est reliée à la sortie (19) de la deuxième porte ($OU_2$) d'inhibition, la sortie ($S_{11}$) de la troisième porte ($OU_3$) d'inhibition constituant la sortie de sécurité ($S_{11}$) du circuit d'inhibition reliée à l'autre entrée de sécurité (5) de la deuxième porte ($ET_1$) d'alarme, une porte ($ET_3$) à $m-1$ entrées ($E_{11}$, $E_{12}$, $E_{13}$) constituant les $m-1$ autres entrées de sécurité du circuit d'inhibition (4), la sortie de cette porte ($ET_3$) étant reliée à l'autre entrée (17) de la deuxième porte ($OU_2$) d'inhibition, l'autre entrée (21) de la troisième porte ($OU_3$) d'inhibition étant reliée à la sortie ($S_{12}$) de l'inverseur (INV), les $m-1$ entrées ($E_{11}$, $E_{12}$, $E_{13}$) de la porte ($ET_3$) à $m-1$ entrées étant reliées respectivement aux autres sorties des inverseurs des circuits d'inhibition des $m-1$ autres voies, pour recevoir ledit autre signal de sécurité.

8. Système selon l'une quelconque des revendications 1, 2 et 5, caractérisé en ce que le circuit logique de commande d'actionnement (2) est du type »à logique dynamique et à sécurité positive«.

9. Système selon l'une quelconque des revendications 1 à 7, caractérisé en ce qu'il comporte quatre voies redondantes.

**Patentansprüche**

1. Logisches Sicherheitssystem zum Auslösen der Schutztätigkeit eines Sicherheitsauslösers (1), mit einer geraden ganzen Zahl m von redundanten Kanälen ($V_1$, $V_2$, $V_3$, $V_4$) zur Auslösesteuerung der Schutztätigkeit, wobei diese Kanäle über Ausgänge ($A_1$, $A_2$, $A_3$, $A_4$) mit Eingängen eines logischen Schaltkreises (2) zur Auslösesteuerung der Schutztätigkeit verbunden sind, durch den diese Tätigkeit jedesmal auslösbar ist, wenn wenigstens zwei von den m Kanälen ein Befehlssignal zum Auslösen der Schutztätigkeit in Abhängigkeit von einem von diesen wenigstens zwei Kanälen empfangenen Warnsignal geliefert haben, dadurch gekennzeichnet, daß jeder Kanal einen logischen Warnschaltkreis (3), der das Warnsignal an einem Eingang ($D_1$) empfangen kann, und einen logischen Sperrschaltkreis (4) für den logischen Warnschaltkreis (3) aufweist, der an einem Steuereingang ($I_1$) ein Sperrsignal von dem logischen Warnschaltkreis (3) empfangen kann, wobei dieser Sperrschaltkreis mit einem Sperreingang (6) des Warnschaltkreises verbunden ist, der ein Sperrsignal von dem entsprechenden Kanal empfangen kann, daß der jeweilige logische Alarmschaltkreis (3) und Sperrschaltkreis (4) eines jeden Kanals derart ausgebildet und verbunden sind, daß, wenn der logische Sperrschaltkreis (4) von einem ersten der gesamten Kanäle an seinem Sperreingang ($I_1$) ein Sperrsignal erhält, während dieses Signal bereits von einem Sperreingang ($I_2$) eines logischen Sperrschaltkreises eines zweiten Kanals der gesamten Kanäle empfangen worden ist, der logische Sperrschaltkreis (4) dieses ersten Kanals über einen Sicherheitsausgang ($S_{11}$) an einen Sicherheitseingang (5) des entsprechenden Warnschaltkreises ein Sicherheitssignal gibt, welches an einem Ausgang ($A_1$) des Warnschaltkreises, welcher dem Ausgang dieses ersten Kanals entspricht, das Auftreten eines Steuersignals zum Auslösen der Schutztätigkeit hervorruft.

2. Logisches System nach Anspruch 1, dadurch gekennzeichnet, daß der Sperrschaltkreis (4) eines jeden Kanals ferner $m-1$ Sicherheitseingänge ($E_{11}$, $E_{12}$, $E_{13}$) umfaßt, die mit den entsprechenden Sicherheitsausgängen ($S_{22}$, $S_{32}$, $S_{42}$) der Sperrschaltkreise der $m-1$ anderen Kanälen verbunden sind, und daß der Sperrschaltkreis (4) eines jeden Kanals somit über einen Sicherheitsausgang ($S_{12}$), der entsprechend mit einem der $m-1$ Sicherheitseingängen jedes Sperrschaltkreises der anderen Kanäle verbunden ist, ein weiteres Sicherheitssignal abgibt, welches den gesperrten oder nicht gesperrten Zustand des Warnschaltkreises eines jeden Kanals anzeigt.

3. System nach Anspruch 2, dadurch gekennzeichnet, daß jeder logische Warnschaltkreis (3) ein Warntor ($ET_1$) mit zwei Eingängen (6, $D_1$), wobei einer dieser Eingänge ($D_1$) das Warnsignal empfangen kann und der andere Eingang (6) den Sperreingang dieses Schaltkreises bildet, und ein Alarmtor ($OU_1$) mit zwei Eingängen (5, 7) umfaßt, wobei einer (7) dieser Eingänge mit einem Ausgang des Tores ($ET_1$) verbunden ist, während ein anderer Eingang (5) des Tores ($OU_1$) den Sicherheitseingang des Warnschaltkreises bildet, der mit dem Sicherheitsausgang ($S_{11}$) des Sperrschaltkreises (4) verbunden ist, und daß der Ausgang dieses Tores ($OU_1$) den Ausgang ($A_1$) des Warnschaltkreises (3) bildet, der mit dem logischen Steuerkreis (2) verbunden ist.

4. System nach Anspruch 3, dadurch gekennzeichnet, daß jeder logische Sperrschaltkreis (4) einen Inverter (INV), dessen einer Eingang ($I_1$) das Sperrsignal empfangen kann, wobei ein Ausgang ($S_{12}$) dieses Inverters mit einem Eingang (6) des Warntores ($ET_1$) verbunden ist, der den Sperreingang des Warnschaltkreises (3) bildet, ein erstes Sperrtor ($ET_2$) mit zwei Eingängen (8, 9), wobei ein erster Eingang (8) mit dem Eingang ($I_1$) des Inverters (INV) verbunden ist, ein zweites Sperrtor ($OU_2$) mit zwei Eingängen (10, 11), wobei ein Eingang (10) mit dem Ausgang des ersten Sperrtores ($ET_2$) mit zwei Eingängen verbunden ist, der Ausgang ($S_{11}$) des zweiten Tores ($OU_2$) einerseits mit dem anderen Eingang (9) des ersten Sperrtores ($ET_2$) mit zwei Eingängen und andererseits mit dem Sicherheitseingang (5)

des Alarmtores ($OU_1$) verbunden ist, und ein Tor ($ET_3$) mit m Eingängen ($ET_{11}$, $ET_{12}$, $ET_{13}$, $ET_{14}$) umfaßt, wobei m−1 diese Eingänge die m−1 Sicherheitseingänge des Sperrschaltkreises (4) bilden und der Ausgang (11) dieses Tores ($ET_3$) mit m Eingängen mit dem anderen Eingang (11) des zweiten Sperrtores ($OU_2$) verbunden ist, und wobei der m-te Eingang ($E_{14}$) des Tores ($ET_3$) mit vier Eingängen mit dem Ausgang ($S_{12}$) des Inverters (INV) verbunden ist, während die m−1 anderen Eingänge ($E_{11}$, $E_{12}$, $E_{13}$) dieses Tores mit den entsprechenden Ausgängen ($S_{22}$, $S_{32}$, $S_{42}$) der Inverter der Sperrschaltkreise der drei anderen Kanäle verbunden sind.

5. System nach Anspruch 1, dadurch gekennzeichnet, daß der Sperrschaltkreis (4) eines jeden Kanals m−1 Sicherheitseingänge ($E_{11}$, $E_{12}$, $E_{13}$) aufweist, daß ein Ausgang ($S_{12}$) des Sperrschaltkreises eines jeden Kanals mit dem entsprechenden der m−1 Sicherheitseingänge der Sperrschaltkreise der anderen Kanäle verbunden ist, und daß der Sperrschaltkreis eines der Kanäle somit über seinen Ausgang ($S_{12}$), der mit einem der m−1 Sicherheitseingänge der Sperrschaltkreise der anderen Kanäle verbunden ist, ein anderes Sicherheitssignal abgibt, welches den gesperrten oder nicht gesperrten Zustand des Warnschaltkreises eines jeden Kanals anzeigt.

6. System nach Anspruch 5, dadurch gekennzeichnet, daß jeder logische Warnschaltkreis (3) ein erstes Warntor ($OU_1$) mit zwei Eingängen (6, $D_1$), wobei einer dieser Eingänge ($D_1$) das Warnsignal empfangen kann, während der andere Eingang (6) den Sperreingang dieses Schaltkreises bildet, und ein zweites Warntor ($ET_1$) mit zwei Eingängen (5, 14) aufweist, wobei einer dieser Eingänge (14) mit einem Ausgang des ersten Tores ($OU_1$) verbunden ist, während ein anderer Eingang (5) des zweiten Tores ($ET_1$) den Sicherheitseingang des mit dem Sicherheitsausgang ($S_{11}$) des Sperrschaltkreises (4) verbundenen Warnschaltkreises bildet, und daß der Ausgang ($A_1$) dieses Tores ($ET_1$) den Ausgang des Warnschaltkreises bildet, der mit dem logischen Steuerschaltkreis (2) verbunden ist.

7. System nach Anspruch 6, dadurch gekennzeichnet, daß jeder logische Sperrschaltkreis (4) umfaßt einen Inverter (INV), dessen einer Eingang ($I_1$) das Sperrsignal empfangen kann, wobei dieser Eingang ($I_1$) ferner mit dem Sperreingang (6) des ersten Warntores ($OU_1$) verbunden ist, ein zweites Sperrtor ($ET_2$) mit zwei Eingängen (15, 16), wobei ein Eingang (15) mit dem Eingang ($I_1$) des Inverters (INV) verbunden ist, ein zweites Sperrtor ($OU_2$) mit zwei Eingängen (17, 18), wobei einer (18) dieser Eingänge mit dem Ausgang des ersten Sperrtores ($ET_2$) mit zwei Eingängen und sein Ausgang (19) mit dem anderen Eingang (16) des ersten Sperrtores ($ET_2$) mit zwei Eingängen verbunden ist, ein drittes Sperrtor ($OU_3$) mit zwei Eingängen (20, 21), von denen ein Eingang (20) mit dem Ausgang (19) des zweiten Sperrtores ($OU_2$) verbunden ist und der Ausgang ($S_{11}$) des dritten Sperrtores ($OU_3$) den Sicherheitsausgang ($S_{11}$) des Sperrschaltkreises bildet und mit dem anderen Sicherheitseingang (5) des zweiten Warntores ($ET_1$) verbunden ist, sowie ein Tor ($ET_3$) mit m−1 Eingängen ($E_{11}$, $E_{12}$, $E_{13}$), die die m−1 anderen Sicherheitseingänge des Sperrschaltkreises (4) bilden, daß der Ausgang dieses Tores ($ET_3$) mit dem anderen Eingang (17) des zweiten Sperrtores ($OU_2$) verbunden ist, daß der andere Eingang (21) des dritten Sperrtores ($OU_3$) mit dem Ausgang ($S_{12}$) des Inverters (INV) verbunden ist, und daß die m−1 Eingänge ($E_{11}$, $E_{12}$, $E_{13}$) des Tores ($ET_3$) mit m−1 Eingängen mit den entsprechenden Ausgängen der Inverter der Sperrschaltkreise der m−1 anderen Kanäle verbunden sind, um das Sicherheitssignal zu empfangen.

8. System nach irgendeinem der Ansprüche 1, 2 oder 5, dadurch gekennzeichnet, daß der logische Schaltkreis zur Betätigungssteuerung (2) von der Art mit dynamischer Logik und positiver Sicherheit ist.

9. System nach irgendeinem der Ansprüche 1 bis 7, dadurch gekennzeichnet, daß es vier redundante Kanäle umfaßt.

## Claims

1. Logic safety system for releasing the protective action of a safety actuator (1), comprising a whole number m of redundant command modules ($V_1$, $V_2$, $V_3$, $V_4$), for releasing the protective action, said modules being connected by outputs ($A_1$, $A_2$, $A_3$, $A_4$) to inputs of a logic circuit (2) for commanding release of the protective action, adapted to release said action each time at least two of the m modules have provided a signal commanding release of the protective action, in response to an alarm signal received by at least said two modules, characterized in that each of the modules comprises an alarm logic circuit (3) adapted to receive the alarm signal at an input ($D_1$), an inhibition logic circuit (4) for the alarm logic circuit (3) adapted to receive at a command input ($I_1$) an inhibition command signal for the alarm logic circuit (3), said inhibition circuit being connected to an inhibition input (6) of the alarm circuit adapted to receive an inhibition signal from a corresponding module, the alarm (3) and inhibition (4) logic circuits of each module being formed and connected in such a manner that, when the inhibition logic circuit (4) of a first module of all said modules receives an inhibition command signal at its inhibition command input ($I_1$), while said signal has already been received by an inhibition command input ($I_2$) of an inhibition logic circuit of a second module of all said modules, the inhibition logic circuit (4) of said first module supplies, from a security output ($S_{11}$) to a security input (5) of a corresponding alarm circuit, a security signal that causes a signal commanding release of the protective action to be produced at an output ($A_1$) of the alarm circuit corresponding to the output of said first module.

2. Logic system according to Claim 1, characterized in that the inhibition circuit (4) of each module additionally comprises m − 1 security inputs ($E_{11}$, $E_{12}$, $E_{13}$) respectively connected to security outputs ($S_{22}$, $S_{32}$, $S_{42}$) of the inhibition circuits of the m − 1 other modules, the inhibition circuit (4) of each module thereby supplying another security signal indicating the inhibited or non-inhibited state of the alarm circuit of that module, through a security output ($S_{12}$) respectively connected to each of the m − 1 security inputs of the inhibition circuits of the other modules.

3. System according to Claim 2, characterized in that each alarm logic circuit (3) comprises an alarm gate ($ET_1$) having two inputs (6, $D_1$), one of said inputs ($D_1$) being adapted to receive the alarm signal while the other input (6) constitutes the inhibition input of said circuit, and an alert gate ($OU_1$) having two inputs (5, 7), one of said inputs (7) being connected to the output of the alarm gate ($ET_1$), while the other input (5) of the alert gate ($OU_1$) constitutes the security input of the alarm circuit connected to the security output ($S_{11}$) of the inhibition circuit (4), the output of the alert gate ($OU_1$) constituting the output ($A_1$) of the alarm circuit (3), connected to the command logic circuit (2).

4. System according to Claim 3, characterized in that each inhibition logic circuit (4) comprises an inverter (INV), one input ($I_1$) of which is adapted to receive the inhibition command signal, an output ($S_{12}$) of said inverter being connected to an input (6) of the alarm gate ($ET_1$) which constitutes the inhibition input of the alarm circuit (3), a first inhibition gate ($ET_2$) with two inputs (8, 9), of which a first input (8) is connected to the input ($I_1$) of the inverter (INV), a second inhibition gate ($OU_2$) with two inputs (10, 11), of which one input (10) is connected to the output of the first inhibition gate ($ET_2$) having two inputs, the output ($S_{11}$) of the second inhibition gate ($OU_2$) being connected, on the one hand to the other input (9) of the first inhibition gate ($ET_2$) with two inputs, and on the other hand to the security input (5) of the alert gate ($OU_1$), and a gate ($ET_3$) having m inputs ($E_{11}$, $E_{12}$, $E_{13}$, $E_{14}$), m − 1 of these inputs constituting the m − 1 security inputs of the inhibition circuit (4), the output (11) of said gate ($ET_3$) with m inputs being connected to the other input (11) of the second inhibition gate ($OU_2$), the $m^{th}$ input ($E_{14}$) of said gate ($ET_3$) having four inputs being connected to the output ($S_{12}$) of the inverter (INV), while the m − 1 other inputs ($E_{11}$, $E_{12}$, $E_{13}$) of said gate are respectively connected to the outputs ($S_{22}$, $S_{32}$, $S_{42}$) of the inverters of the inhibition circuits of the three other modules.

5. System according to Claim 1, characterized in that the inhibition circuit (4) of each module comprises m − 1 security inputs ($E_{11}$, $E_{12}$, $E_{13}$), an output ($S_{12}$) of the inhibition circuit of each module being respectively connected to one of the m − 1 security inputs of the inhibition circuits of each of the other modules, the inhibition circuit of each of the modules thereby supplying, by its output ($S_{12}$) connected to one of the m − 1 security inputs of the inhibition circuits of each of the other modules, another security signal indicating the inhibited or non-inhibited state of the alarm circuit of each module.

6. System according to Claim 5, characterized in that each alarm logic circuit (3) comprises a first alarm gate ($OU_1$) with two inputs (6, $D_1$), one of said inputs ($D_1$) being adapted to receive the alarm signal, while the other input (6) constitutes the inhibition input of the circuit, and a second alarm gate ($ET_1$) with two inputs (5, 14), one of said inputs (14) being connected to an output of the first alarm gate ($OU_1$) while another input (5) of the second alarm gate ($ET_1$) constitutes the security input of the alarm circuit connected to the security output ($S_{11}$) of the inhibition circuit (4), the output ($A_1$) of said second alarm gate ($ET_1$) constituting the output of the alarm circuit connected to the command logic circuit (2).

7. System according to Claim 6, characterized in that each inhibition logic circuit (4) comprises an inverter (INV), an input ($I_1$) of which is adapted to receive the inhibition command signal, said input ($I_1$) being additionally connected to the inhibition input (6) of the first alarm gate ($OU_1$), a first inhibition gate ($ET_2$) with two inputs (15, 16) of which an input (15) is connected to the input ($I_1$) of the inverter (INV), a second inhibition gate ($OU_2$) with two inputs (17, 18) one of whose inputs (18) is connected to the output of the first inhibition gate ($ET_2$) having two inputs, and whose output (19) is connected to the other input (16) of the first inhibition gate ($ET_2$) having two inputs, a third inhibition gate ($OU_3$) with two inputs (20, 21), one of whose inputs (20) is connected to the output (19) of the second inhibition gate ($OU_2$), the output ($S_{11}$) of the third inhibition gate ($OU_3$) constituting the security output ($S_{11}$) of the inhibition circuit connected to the other security input (5) of the second alarm gate ($ET_1$), a gate ($ET_3$) with m − 1 inputs ($E_{11}$, $E_{12}$, $E_{13}$) constituting the m − 1 other security inputs of the inhibition circuit (4), the output of said gate ($ET_3$) being connected to the other input (17) of the second inhibition gate ($OU_2$), the other input (21) of the third inhibition gate ($OU_3$) being connected to the output ($S_{12}$) of the inverter (INV), the m − 1 inputs ($E_{11}$, $E_{12}$, $E_{13}$) of the gate ($ET_3$) with m − 1 inputs being respectively connected to the outputs of the inverters of the inhibition circuits of each of the m − 1 other modules, to receive said other security signal.

8. System according to any one of Claims 1, 2 and 5, characterized in that the logic circuit (2) commanding functioning of the system is of the »positive security dynamic logic« type.

9. System according to any one of Claims 1 to 7, characterized in that it comprises four redundant modules.

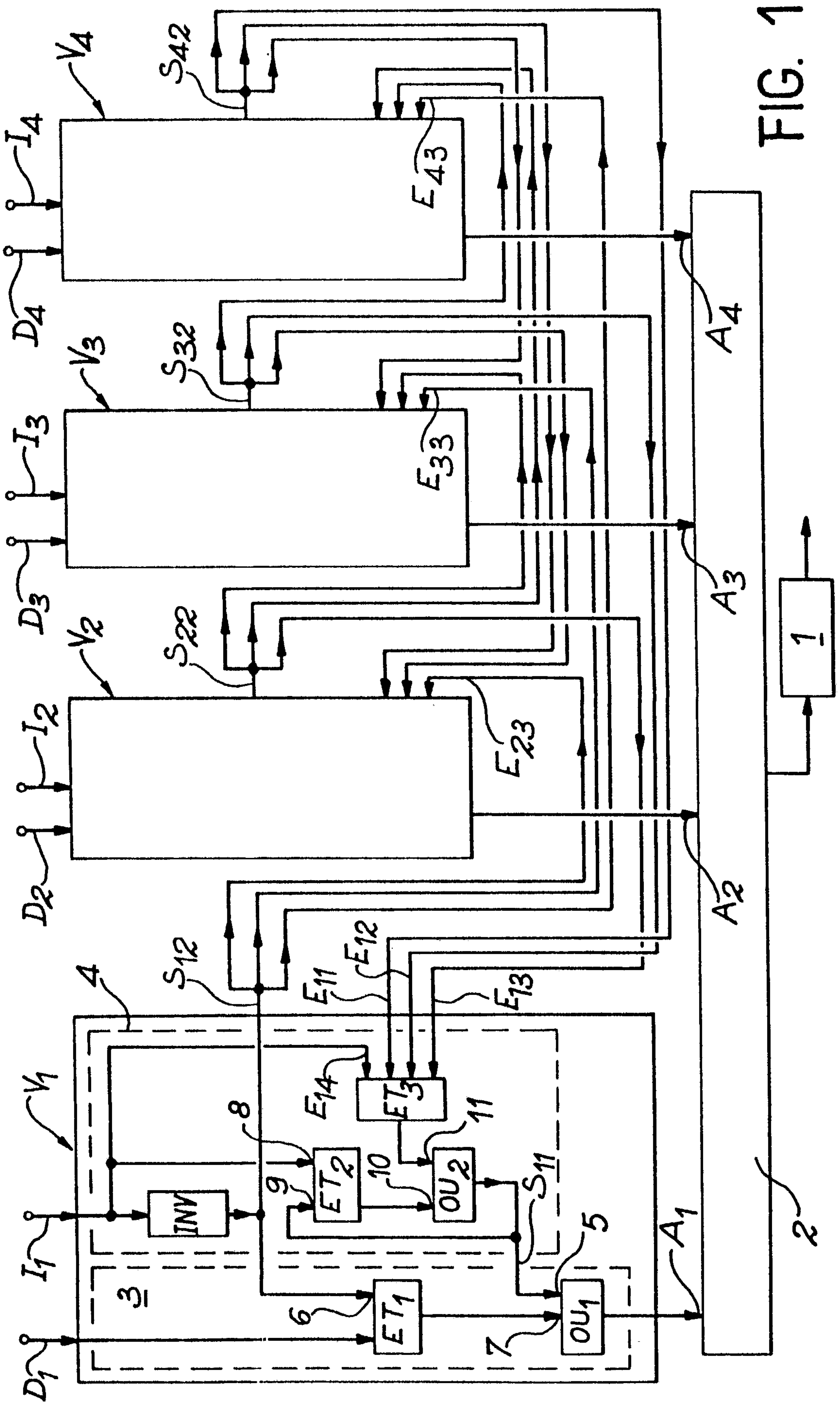

D1
I1
V1
4
3
INV
ET1
ET2
ET3
OU1
OU2
5
6
7
8
9
10
11
S11
S12
E11
E12
E13
E14
A1
D2
I2
V2
S22
E23
A2
D3
I3
V3
S32
E33
A3
D4
I4
V4
S42
E43
A4
1
2


FIG. 1

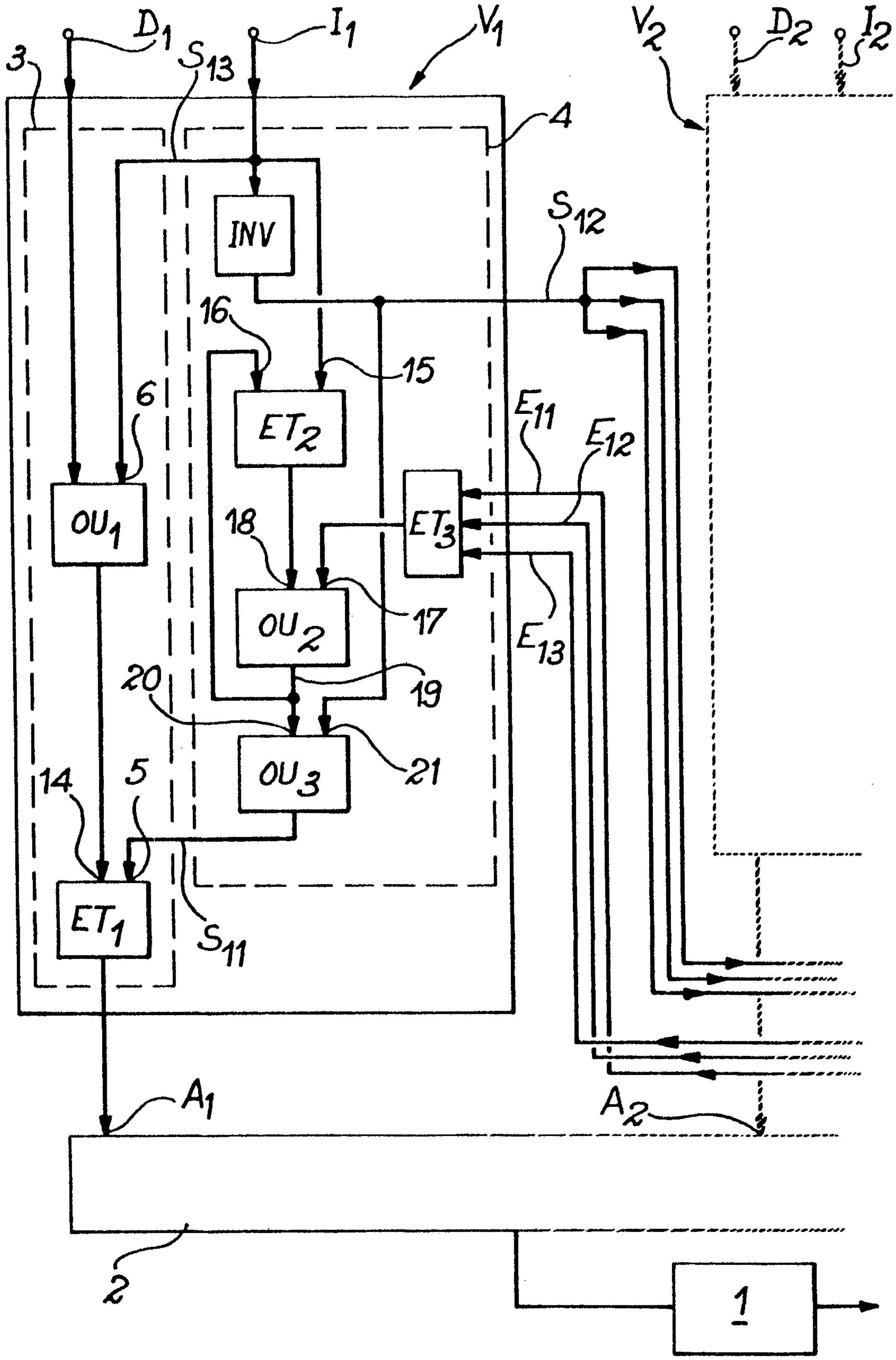
D1
I1
V1
V2
D2
I2
3
S13
4
INV
S12
16
15
ET2
6
E11
E12
OU1
ET3
18
OU2
17
E13
20
19
OU3
21
14
5
ET1
S11
A1
A2
2
1

FIG. 2

| | $I_1$ | $D_1$ | $S_{12}$ | $E_{11}$ | $E_{12}$ | $E_{13}$ | $ET_1$ | $ET_3$ | $ET_2$ | $S_{11}$ | $A_1$ |
|---|---|---|---|---|---|---|---|---|---|---|---|
| $C_1$ | 0 | 1 | 1 | 1 | 1 | 1 | 1 | 0 | 0 | 0 | 1 |
| $C_2$ | 0 | 0 | 1 | 1 | 1 | 1 | 0 | 0 | 0 | 0 | 0 |
| $C_3$ | 1 | 1/0 | 0 | 1 | 1 | 1 | 0 | 1 | 1 | 1 | 1 |
| $C_4$ | 0 | 1/0 | 1 | 1 | 1 | 0 | 1/0 | 0 | 0 | 0 | 1/0 |
| $C_5$ | 0/1 | 1 | 1/0 | 1 | 1 | 0 | 1/0 | 0 | 0 | 0 | 1/0 |
| $C_6$ | 1 | | 0 | 1 | 1 | 1/0 | 0 | 0 | 1 | 1 | 1 |

FIG. 3

| | $I_1$ | $D_1$ | $S_{12}$ | $E_{11}$ | $E_{12}$ | $E_{13}$ | $OU_1$ | $ET_3$ | $OU_2$ | $ET_2$ | $S_{11}$ | $A_1$ |
|---|---|---|---|---|---|---|---|---|---|---|---|---|
| $C_1$ | 0 | 1 | 1 | 1 | 1 | 1 | 1 | 1 | 1 | 0 | 1 | 1 |
| $C_2$ | 0 | 0 | 1 | 1 | 1 | 1 | 0 | 1 | 1 | 0 | 1 | 0 |
| $C_3$ | 1 | 1/0 | 0 | 1 | 1 | 1 | 1 | 1 | 1 | 1 | 1 | 1 |
| $C_4$ | 0 | 1/0 | 1 | 1 | 1 | 0 | 1/0 | 0 | 0 | 0 | 1 | 1/0 |
| $C_5$ | 0/1 | 1 | 1/0 | 1 | 1 | 0 | 1 | 0 | 0 | 0 | 1/0 | 1/0 |
| $C_6$ | 1 | | 0 | 1 | 1 | 1/0 | 1 | 1/0 | 1 | 1 | 1 | 1 |

FIG. 4